# EUROPEAN PATENT APPLICATION

(11) **EP 4 848 919 A1**
(43) Date of publication of application: **02.12.2026**
(21) Application number: 26181741.5
(22) Date of filing: 28.05.2026
(51) Int. Cl.: H05K 7/20

(54) **HEAT TRANSFER BETWEEN RACK AND MANIFOLD WITHOUT TWO PHASE CONNECTORS**

(30) Priority: 29.05.2025 US 202563814053 P
(71) Applicant: Carrier Corporation, Palm Beach Gardens, FL 33418 (US)
(72) Inventor: Grabon, Michel, Montluel, 01120 (FR); Sienel, Tobias, NY 13057 (US); Stark, Michael, NC 28269 (US); Lord, Richard, TN 37356 (US); Joardar, Arindom, NY 13057 (US)
(74) Representative: Dehns

(57) **Abstract**

A cooling system (20) for a server (54) mounted in a rack (52) of a data center (50) includes a first portion (80) of a heat recovery heat exchanger (56), and a rack cooling circuit (64) fluidly connected to the first portion (80) of the heat recovery heat exchanger (56) and fluidly connectable to the server (54). A working fluid (W) is circulatable through the rack cooling circuit (64). The first portion (80) of the heat recovery heat exchanger (56) is movable between an engaged position and a disengaged position. In the engaged position, the first portion (80) of the heat recovery heat exchanger (56) is engaged with a second portion (82) of the heat recovery heat exchanger (56) located at the rack (52) of the data center (50). In the disengaged position, the first portion (80) of the heat recovery heat exchanger (56) is located remotely from the second portion (82) of the heat recovery heat exchanger (56).

## Description

### BACKGROUND

Exemplary embodiments pertain to the art of thermal management, and more particularly, relate to thermal management of a server within a data center.

A "data center" refers to the physical location of one or more servers. A data center and the servers housed within a data center typically consume a significant amount of electrical power. Existing servers are designed to be cooled at least partially by a flow of air. Such servers usually include one or more printed circuit boards having a plurality of operable heat-generating devices mounted thereto. The printed circuit boards are commonly housed in an enclosure having vents configured to direct external air from the data center into, through and out of the enclosure. The air absorbs heat dissipated by the components and after being exhausting from the enclosure, mixes with the ambient air. An air conditioner is then used to cool the heated air of the data center and to recirculate it, repeating the cooling process.

Higher performance server components typically dissipate more power. However, the amount of heat that a conventional air-cooled cooling system can remove from a server is in part limited by the extent of the air flow available and air proprieties relative to heat transfer capacity of the air. To increase the power density of a cooling system, liquid cooling is required. Liquid cooling allows significant increase of dissipated heat from servers.

To transfer heat away from a server, the use of a two-phase fluid is the most efficient. However, such a configuration requires fluid connections between the two respective fluid loops. Using traditional fluid connections will require at least two connections between each server and the rack system. Large data centers, such as having twenty servers per rack and more than one hundred racks, would require thousands of fluid connections which eventually will lead to high probability of system failure. Each of these fluid connections is susceptible to leaks, thereby resulting in reliability issues.

### BRIEF DESCRIPTION

Viewed from a first aspect, a cooling system for a server mounted in a rack of a data center is provided. The cooling system includes a first portion of a heat recovery heat exchanger, and a rack cooling circuit fluidly connected to the first portion of the heat recovery heat exchanger and fluidly connectable to the server. A working fluid is circulatable through the rack cooling circuit. The first portion of the heat recovery heat exchanger is movable between an engaged position and a disengaged position. In the engaged position, the first portion of the heat recovery heat exchanger is engaged with a second portion of the heat recovery heat exchanger located at the rack of the data center. In the disengaged position, the first portion of the heat recovery heat exchanger is located remotely from the second portion of the heat recovery heat exchanger.

The first portion of the heat recovery heat exchanger may be thermally coupled to the second portion of the heat recovery heat exchanger only when in the engaged position.

The first portion of the heat recovery heat exchanger may be mechanically coupled to the second portion of the heat recovery heat exchanger only when in the engaged position.

The first portion of the heat recovery heat exchanger may include at least one first engagement feature. In the engaged position, the at least one first engagement feature is interleaved with at least one second engagement feature of the second portion of the heat recovery heat exchanger.

The at least one first engagement feature may include a plurality of first fins and a plurality of first cavities defined between adjacent first fins of the plurality of first fins.

The at least one second engagement feature may include a plurality of second fins and a plurality of second cavities defined between adjacent second fins of the plurality of first fins.

A size and shape of each of the plurality of second fins may be identical to the size and shape of a corresponding first cavity of the plurality of first cavities.

A size and shape of each of the plurality of first fins may be identical to the size and shape of a corresponding second cavity of the plurality of second cavities.

An orientation of one or more of the at least one first engagement feature and the at least one second engagement feature may be adjustable relative to the server.

The server may have a structural body and the first portion of the heat recovery heat exchanger is located remotely from the structural body.

The server may have a structural body and the first portion of the heat recovery heat exchanger is integrated into the structural body.

Viewed from a second aspect, there is provided a data center. The data center includes a rack and a server removably mountable within the rack. A rack cooling circuit includes a first portion of a heat recovery heat exchanger and the server and a working fluid being circulatable through the rack cooling circuit. A secondary cooling circuit, fluidly separate from the rack cooling circuit, includes a second portion of the heat recovery heat exchanger. A coolant is circulatable through the secondary cooling circuit. The first portion of the heat recovery heat exchanger is movable relative to the second portion of the heat recovery heat exchanger between an engaged position and a disengaged position. In the engaged position, the first portion of the heat recovery heat exchanger and the second portion of the heat recovery heat exchanger are engaged. In the disengaged position, the first portion of the heat recovery heat exchanger is located remotely from the second portion of the heat recovery heat exchanger.

The first portion of the heat recovery heat exchanger may be thermally coupled to the second portion of the heat recovery heat exchanger only when in the engaged position.

The first portion of the heat recovery heat exchanger may be mechanically coupled to the second portion of the heat recovery heat exchanger only when in the engaged position.

The working fluid may be a refrigerant, and the working fluid received at the first portion of the heat recovery heat exchanger may be a two-phase mixture.

The coolant may be water.

The first portion of the heat recovery heat exchanger may include at least one first engagement feature, and in the engaged position, the at least one first engagement feature is interleaved with at least one second engagement feature of the second portion of the heat recovery heat exchanger.

At least one heat transfer element may be thermally coupled to a heat-generating electrical device of the server. The at least one heat transfer element may be fluidly coupled to the rack cooling circuit.

The rack cooling circuit may be configured as a thermosiphon.

The rack cooling circuit may include a pump operable to circulate working fluid through the rack cooling circuit.

### BRIEF DESCRIPTION OF THE DRAWINGS

The following descriptions should not be considered limiting in any way. With reference to the accompanying drawings, like elements are numbered alike:
FIG. 1 is a schematic diagram of an example of a cooling system;
FIG. 2 is a detailed schematic diagram of a plurality or servers within a rack system;
FIG. 3 is a detailed view of a server of a rack system thermally decoupled from the second cooling system;
FIG. 4A is a detailed view of a first portion and a second portion of a heat recovery heat exchanger in a separated configuration;
FIG. 4B is a detailed view of the first portion and the second portion of the heat recovery heat exchanger of FIG. 4A in an engaged configuration;
FIG. 5A is a detailed view of a first portion and a second portion of a heat recovery heat exchanger in a separated configuration;
FIG. 5B is a detailed view of the first portion and the second portion of the heat recovery heat exchanger of FIG. 5A in an engaged configuration;
FIG. 6 is a plan view of a fin of the second portion of the heat recovery heat exchanger;
FIG. 7 is a schematic diagram of a second cooling system including the second portion of a plurality of heat recovery heat exchangers;
FIG. 8 is a schematic diagram of a first portion of a heat recovery heat exchanger integrated into the structural body of a server;
FIG. 9A is a plan view of a server having a first portion of a heat recovery heat exchanger external to the structural body and in a first orientation;
FIG. 9B is a side view of the server of FIG. 9A;
FIG. 10A is a plan view of the server of FIG. 9A having a first portion of a heat recovery heat exchanger in a second orientation;
FIG. 10B is a side view of the server of FIG. 10A;
FIG. 11A is a plan view of a server having a first portion of a heat recovery heat exchanger external to the structural body and engaged with the second portion of the heat recovery heat exchanger;
FIG. 11B is a side view of the server of FIG. 11A;
FIG. 12A is a plan view of a server having a first portion of a heat recovery heat exchanger external to the structural body and a second portion of a heat recovery heat exchanger in a first orientation;
FIG. 12B is a side view of the server of FIG. 12A;
FIG. 13A is a plan view of a server having a first portion of a heat recovery heat exchanger engaged with the second portion of the heat recovery heat exchanger, the second portion of the heat recovery heat exchange being arranged in a second orientation;
FIG. 13B is a side view of the server of FIG. 13A;
FIG. 14A is a plan view of a back of a server and a heat recovery heat exchanger assembly fluidly connected thereto; and
FIG. 14B is a back view of the first portion of the heat recover heat exchanger assembly of FIG. 14A fluidly connected to the server.

### DETAILED DESCRIPTION

A detailed description of one or more embodiments of the disclosed apparatus and method are presented herein by way of exemplification and not limitation with reference to the Figures.

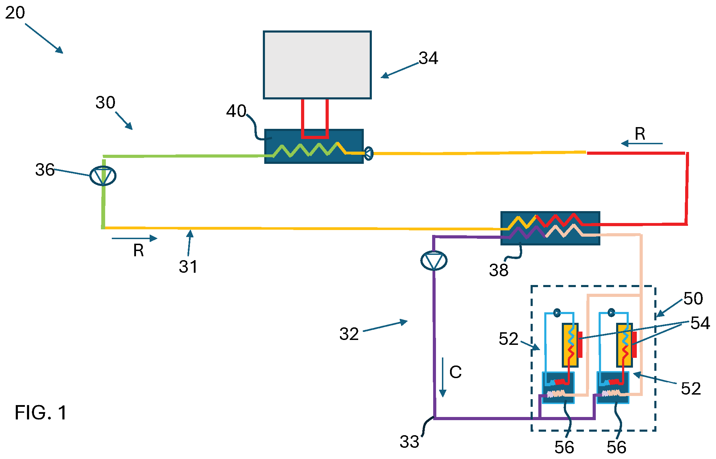

Referring to FIG. 1, an example of a cooling system 20 is illustrated. As shown, the cooling system 20 includes a first cooling system 30 and a plurality of loads thermally coupled to the first cooling system 30. As used herein, the term "load" is intended to apply to any secondary system or component that is thermally coupled to the first cooling system 30, regardless of whether the secondary system or component is configured to transfer heat to the first cooling system 30 or remove heat from the first cooling system 30. In the illustrated, non-limiting embodiment, the plurality of loads of the first cooling system 30 includes a first load 32 and a second load 34. However, it should be appreciated that embodiments having any number of loads connected to the first cooling system 30, such as three loads, four loads, or five loads for example, are within the disclosure. Examples of suitable loads include but are not limited to a data center cooling system, an air conditioning system such as an air handling unit, a chiller system, a heat pump, and a sanitary or potable water system.

As shown, the first cooling system 30 includes a primary cooling circuit 31 through which a primary heat transfer fluid R circulates. Examples of suitable heat transfer fluids F include but are not limited to water, propylene glycol, dielectric fluid, and refrigerant. The first cooling system 30 may include a pump or other movement device 36 for moving the heat transfer fluid R through the primary cooling circuit 31. In some embodiments, the primary cooling circuit 31 may include one or more valves (not shown), such as to allow the heat transfer fluid R to selectively bypass one or more of the loads. Although the primary cooling circuit 31 is illustrated as having a closed loop configuration, embodiments where the primary cooling circuit 31 is not a closed loop are also contemplated herein.

The first cooling system 30 is configured to transfer heat between the plurality of loads. In the simplified first cooling system 30 illustrated in the embodiment of FIG. 1, the heat transfer fluid R is configured to absorb heat from the first load 32 and transfer heat to the second load 34. Although the primary cooling circuit 31 is illustrated as being thermally coupled to the one or more loads via heat exchangers, such as a first heat exchanger 38 and a second heat exchanger 40, respectively, it should be appreciated that embodiments where the primary cooling circuit 31 is thermally coupled to the at least one load in another suitable manner are within the scope of the disclosure.

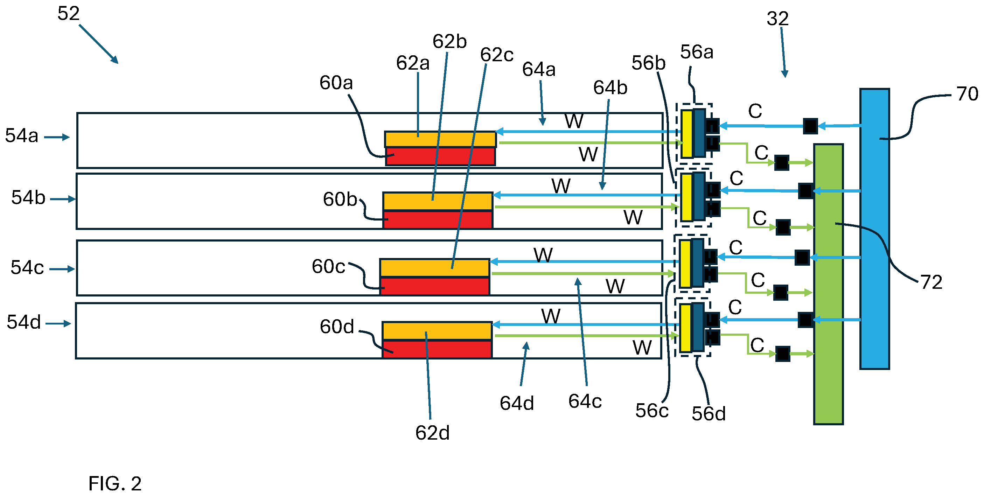

In the illustrated, non-limiting embodiment, the first load 32 is a second cooling system, such as a data center cooling system for example, and includes a secondary cooling circuit 33 through which a coolant or secondary cooling fluid C is configured to circulate. In some embodiments, the coolant C is a liquid, such as water, propylene glycol, or dielectric fluid for example. The second cooling system 32 is associated with one or more data centers 50, each having at least one rack system 52 containing at least one server or assembly having heat-generating electronic devices (referred to herein as "servers") therein (see FIG. 2). As shown, the rack system 52 includes at least one heat recovery component 56 configured to receive a flow of the coolant C. In the illustrated, non-limiting embodiment, the heat recovery component 56 is a heat exchanger. However, in other embodiments the heat recovery component 56 may be a cold plate or other suitable heat transfer device. Within each heat recovery component 56, heat is transferred from the rack system 52, such as from the one or more components of the at least one server 54 arranged therein, to the coolant C. In embodiments where a data center 50 includes a plurality of rack systems 52, as shown in FIG. 1, the coolant C is provided to the heat recovery component 56 associated with each rack system 52, or the individual servers 54 thereof, in parallel. The flows of coolant C output from each heat recovery component 56 are then rejoined at a location upstream from the first heat exchanger 38 or other thermal coupling with the first cooling system 30. It should be appreciated that in embodiments wherein the second cooling system 32 alternatively or additionally includes a plurality of data centers 50, the coolant C may be provided to each data center 50 in parallel, and further may be provided to the heat recovery component 56 of each rack system 52 of the plurality of data centers 50 in parallel.

With reference now to FIG. 2, a detailed view of an interface between the second cooling system 32 and a rack system 52 is illustrated in more detail. In the illustrated, non-limiting embodiment, the rack system 52 includes four servers 54a, 54b 54c, 54d, each having at least one heat-generating electrical device, such as a central processing unit, or a graphical processing unit, represented at 60a, 60b, 60c, 60d, that generates heat. In the illustrated, non-limiting embodiment, a heat transfer element 62a, 62b, 62c, 62d, such as a cold plate or heat exchanger for example, is thermally coupled to the at least one heat-generating electrical devices 60a, 60b, 60c, 60d of each server 54a, 54b, 54c, 54d.

A closed loop, rack cooling circuit 64a, 64b, 64c, 64d may be associated with each server 54a, 54b 54c, 54d and a working fluid W may circulate therethrough. In an embodiment, the working fluid W is a refrigerant. However, embodiments where the working fluid W is another suitable fluid, such as water, or propylene glycol, for example, are also within the scope of the disclosure. The rack cooling circuit 64a, 64b, 64c, 64d may include a first fluid conduit connected to an inlet of a first pathway of the heat recovery heat exchanger 56a, 56b, 56c, 56d and a second fluid conduit connected to and extending from an outlet of the first pathway of the heat recovery heat exchanger 56a, 56b, 56c, 56d. The first fluid conduit of the rack cooling circuit 64a, 64b, 64c, 64d is configured to receive heated working fluid W from the heat transfer element 62a, 62b, 62c, 62d coupled to at least one electrical component 60a, 60b, 60c, 60d of a server 54a, 54b, 54c, 54d and deliver it to the heat recovery heat exchanger 56a, 56b, 56c, 56d. In an embodiment, the working fluid W provided to heat recovery heat exchanger 56a, 56b, 56c, 56d is a two-phase mixture of liquid and vapor; however, embodiments where the working fluid W is a single phase are also within contemplated herein. The second fluid conduit is operable to receive cooled working fluid W from the heat recovery heat exchanger 56a, 56b, 56c, 56d and deliver it to the at least one heat transfer element 62a, 62b, 62c, 62d of a respective server 54a, 54b, 54c, 54d.

The working fluid W within the rack cooling circuit 64a, 64b, 64c, 64d may be circulated through the closed loop of the rack cooling circuit 64a, 64b, 64c, 64d in any suitable manner. In some embodiments, the rack cooling circuit 64a, 64b, 64c, 64d includes a pump (not shown) operable to circulate the working fluid W through the rack cooling circuit 64a, 64b, 64c, 64d. In other embodiments, the rack cooling circuit 64a, 64b, 64c, 64d may be configured as a thermosiphon that uses heat transfer to the working fluid W via the at least one heat transfer element 62a, 62b, 62c, 62d to move the working fluid W to the heat recovery heat exchanger 56a, 56b, 56c, 56d without the use of a mechanical pump.

As shown, the secondary cooling circuit 33 may include a supply manifold 70 fluidly connected to an inlet of a second pathway of each respective heat recovery heat exchanger 56a, 56b, 56c, 56d, and an outlet manifold 72 fluidly connected to an outlet of the second pathway of each respective heat recovery heat exchanger 56a, 56b, 56c, 56d. Accordingly, the coolant C from the supply manifold 70 may be distributed to the plurality of heat recovery heat exchangers 56a, 56b, 56c, 56d in parallel, and the coolant C output from each heat recovery heat exchanger 56a, 56b, 56c, 56d may be returned to the return manifold 72 in parallel. In the illustrated, non-limiting embodiment, one or more quick connectors may be arranged within the portion of the secondary cooling circuit 33 extending between the supply manifold 70 and an inlet of the second pathway at the heat recovery heat exchanger 56a, 56b, 56c, 56d. Alternatively, or in addition, one or more quick connectors may be positioned between an outlet of the second pathway of the heat recovery heat exchanger 56a, 56b, 56c, 56d and the return manifold 72. As used herein the term "quick connectors" is intended to describe a coupling or fitting that allows for a quick connection and disconnection of fluid lines and that is typically operated by hand, without the use of tools. However, it should be understood that embodiments where no quick connectors are arranged within the secondary cooling circuit 33 are also contemplated herein.

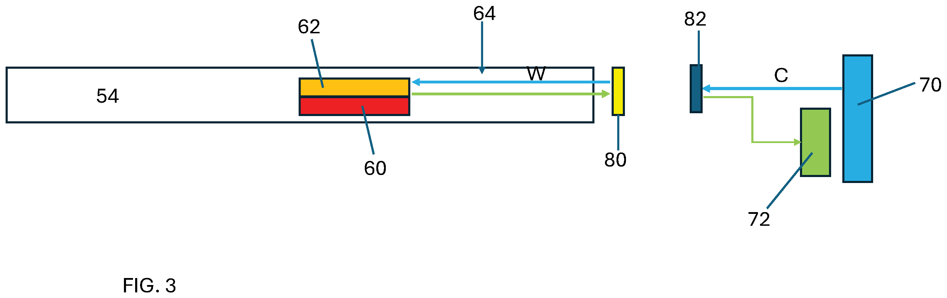

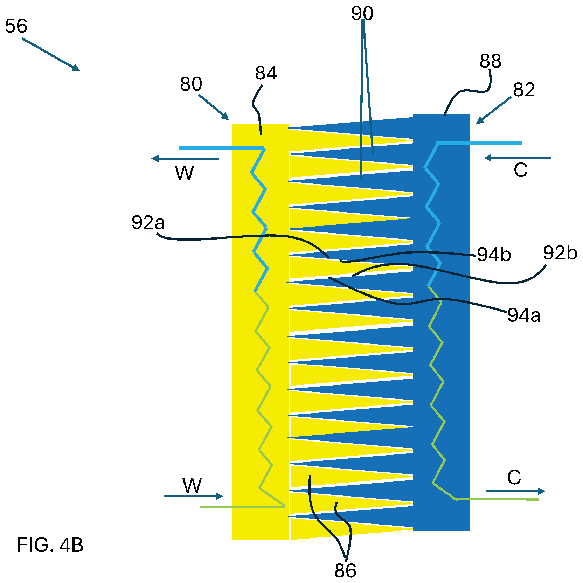

With reference now to FIGS. 3-6, a heat recovery heat exchanger 56, representative of the heat recovery heat exchangers 56a, 56b, 56c, 56d of FIG. 2 is illustrated. As shown, the heat recovery heat exchanger 56 includes a first portion 80 through which the first pathway of the rack cooling circuit 64 extends and a second portion 82 through which the second pathway of the secondary cooling circuit 33 extends. In the illustrated, non-limiting embodiment, the first portion 80 of the heat recovery heat exchanger 56 is transformable between an engaged position (see FIG. 4B), in which the first portion 80 and the second portion 82 are thermally coupled to one another and a disengaged position in which the first portion 82 is not thermally coupled to the first portion 80. When in the engaged position, the first portion 80 of the heat recovery heat exchanger 56 is positioned adjacent to the second portion 82 of the heat recovery heat exchanger 56 and may even be arranged in direct contact with therewith.

In some embodiments, the first portion 80 of the heat recovery heat exchanger 56 is mechanically coupled to the second portion 82 of the heat recovery heat exchanger 56 when in the engaged position. Any suitable coupling mechanism including a magnetic coupling mechanism may be used to form a mechanical link between the first and second portions 80, 82 of the heat recovery heat exchanger 56. However, in some embodiments, when the first portion 80 is in the engaged position, a coupling mechanism may not extend between and couple the first and second portions 80, 82. Accordingly, while the first and second portions 80, 82 may be arranged in contact with one another, no device is operable to restrict movement or separation of the first portion 80 from the second portion 82. In the disengaged position, the first portion 80 may be spaced or located remotely from the second portion 82 of the heat recovery heat exchanger 56.

The first portion 80 of the exemplary heat recovery heat exchanger 56 is mechanically separable from the second portion 82 of the heat recovery heat exchanger 56. Further, in embodiments the first portion 80 is engaged and in direct contact with the second portion 82, the first portion 80 may, but need not be mechanically coupled to the second portion 82. Heat may be transferred from the working fluid W of the first pathway to the coolant C of the second pathway via conduction at an interface between the first portion 80 and the second portion 82. Accordingly, it may be desirable to increase the surface area of each respective portion 80, 82 of the heat recovery heat exchanger 56 positionable in contact a corresponding surface of the other portion 80, 82 of the heat recovery heat exchanger 56 to increase the amount of heat transfer that occurs at the heat recovery heat exchanger 56.

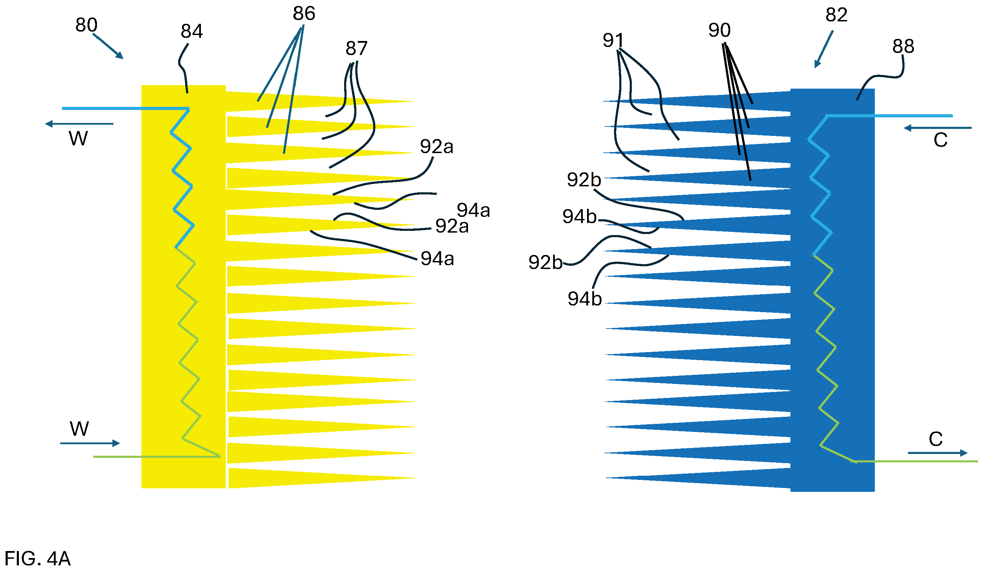

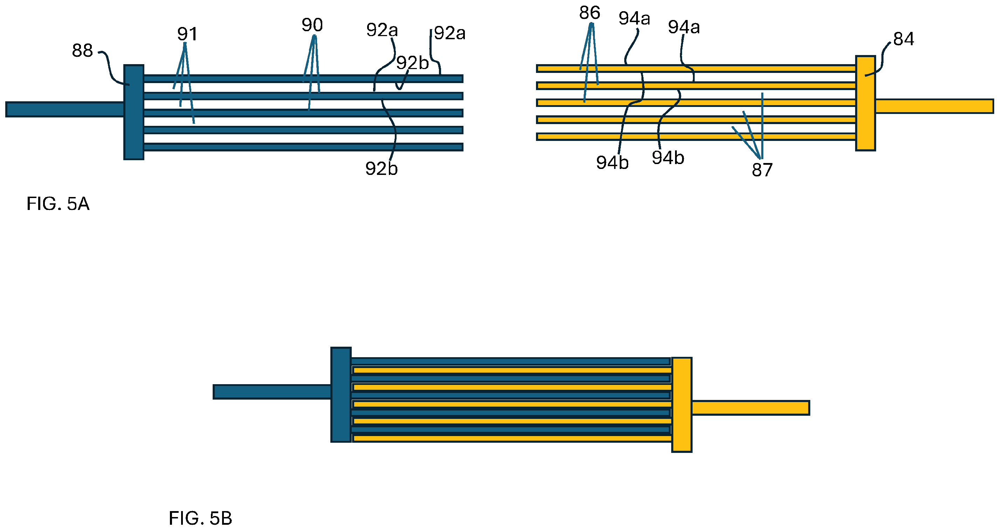

To increase the surface area of the interface between the first portion 80 and the second portion 82 of the heat recovery heat exchanger 56, the first portion 80 may include a base 84 and at least one, and in some embodiments, a plurality of first engagement features 86. The second portion 82 may similarly include a base 88 and at least one, and in some embodiments, a plurality of second engagement features 90. When the first portion 80 is engaged with the second portion 82, the first and second engagement features 86, 90 may be arranged in an interleaved configuration (see FIGS. 4B and 5B). With reference to the embodiments illustrated in FIGS. 4A- 4B, and 5A-5B, the at least one first engagement feature 86 of the first portion 80 includes a plurality of first fins 86 extending from the base 84 in the same direction. The plurality of first fins 86 may be substantially identical in shape and size, and a corresponding first cavity 87 may be formed between adjacent first fins 86.

Similarly, the at least one second engagement feature 90 of the second portion 82 of the heat recovery heat exchanger 56 includes a plurality of second fins 90 extending from the base 88 of the second portion 82 in the same direction. In an embodiment, the second fins 90 extend from base 88 of the second portion 82 in an opposite direction that the first fins 86 extend from the base 84 of the first portion 80. The plurality of second fins 90 may be substantially identical in shape and size, and a corresponding second cavity 91 may be formed between adjacent second fins 90. The second fins 90 may be at least partially receivable within the plurality of first cavities 87, and the first fins 86 may be at least partially receivable within the plurality of second cavities 91.

In an embodiment, the size and shape of a second fin 90 is complementary to the size and shape of a first cavity 87. Alternatively, or in addition, the size and shape of a first fin 86 may be complementary in size and shape to a second cavity 91. In the non-limiting embodiment of FIGS. 4A and 4B, the first fins 86 and the second fins 90 have a cross-section that is triangular in shape, with each fin 86, 90 narrowing in a direction extending away from the base 84, 88 of the corresponding portion 80, 82 of the heat recovery heat exchanger 56. In the embodiment illustrated in FIGS. 5A and 5B, however, the first fins 86 and the second fins 90 are generally rectangular in shape. Both the first and second fins 86, 90 have at least one major surface defined as a surface extending between a corresponding base 84, 88 and the distal end of the fin 86, 90. The fins 86, 90 illustrated in the FIGS. have two major surfaces, identified at 92a, 92b and 94a, 94b, respectively. These major surfaces of the fins 86, 90 typically have the greatest surface area and are oriented so as to face an adjacent fin 86, 90 of the other portion 80, 82. In both of the illustrated, non-limiting embodiments, the two major surfaces 92a, 92b, 94a, 94b of each first fin 86 and second fin 90, except for the outermost fin at each end of the heat recovery heat exchanger 56, is arranged in contact with a major surface 92a, 92b, 94a, 94b of a fin 86, 90 of the other portion 80, 82 of the heat recovery heat exchanger 56.

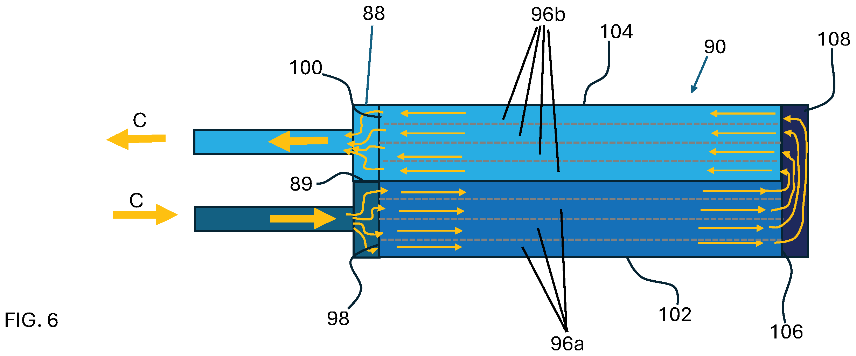

With reference to FIGS. 4A and 4B, the first pathway of the rack cooling circuit 64 is illustrated as extending through the base 84 of the first portion 80 and the second pathway of the secondary cooling circuit 33 is shown extending solely through the base 88 of the second portion 82. In the illustrated, non-limiting embodiment, the first pathway is not shown or described herein as extending into the structural bodies of the plurality of first fins 86 and the second pathway is not shown or described herein as extending into the structural bodies of the second fins 90. However, it may be desirable to increase the amount of heat transfer that occurs at the interleaved first and second fins 86, 90 by extending the pathway into the body of one or more fin 86, 90. Accordingly, embodiments where one or both of the first pathway and the second pathway extends into the structure of one or more of the first fins 86 or the second fins 90, respectively, is also contemplated herein. As shown in the non-limiting embodiment of FIG. 6, the second pathway includes one or more passages that extend over the length of a second fin 90.

The first pathway within the first portion 80 and/or the second pathway within the second portion 82 may be configured to make a single pass, or multiple passes through a corresponding portion of the heat recovery heat exchanger 56. With continued reference to FIG. 6, in an embodiment, one or more fins 86, 90 may be configured as a heat exchange tube, such as a microchannel heat exchange tube for example, having a plurality of discrete flow channels 96a, 96b formed therein. Although a second fin 90 is illustrated in the FIG., it should be understood that a first fin 86 of the first portion 80 may alternatively or additionally have a similar configuration. The discrete flow channels 96a, 96b may extend between an inlet 98 of the fin 90 and an outlet 100 of the fin 90. In such embodiments, the base 88 may function like a manifold having a divider 89 disposed therein. Accordingly, the flow within a portion of the base 88, such as located downstream from the outlet 100 of a fin 90 for example, may include a mixture of the fluid output from at least some, and in some embodiments each, of the plurality of flow channels 96 of the fin 90. The flow channels 96a, 96b may have a circular cross-section, a rectangular cross-section, a trapezoidal cross-section, a triangular cross-section, or another non-circular cross-section. In such embodiments, fluid may be configured to flow through a fin 86, 90 in both a first direction and a second direction.

A fin, such as the second fin 90 for example, may be divided to form a plurality of sections fluidly coupled to one another. In the illustrated, non-limiting embodiment, the plurality of sections of the fin 90 includes a first section 102 and a second section 104 arranged in series relative to a flow of coolant C. Each section 102, 104 of the fin 90 may include one or more flow channels. In the illustrated, non-limiting embodiment, a first group of flow channels 96a are formed within the first section 102 of the fin 90 and a second group of flow channels 96b are formed within the second section 104 of the fin 90. While the first group 96a and the second group 96b are illustrated as having equal numbers of flow channels, embodiments where the number of flow channels in each respective section 102, 104 vary are also contemplated herein. In some embodiments, the first and second sections 102, 104 of the fin 90 are formed by bending the fin 90 about an axis. In other embodiments, a cap 106, similar to an intermediate manifold is connected to a distal end 108 of the fin 90 to direct a flow of coolant C from the first section 102 to the second section 104.

Although the embodiments illustrated in FIGS. 4A-5B show the second portion 82 having a base 88 fluidly connected to a separate supply manifold 70 and return manifold 72, in some embodiments, a supply manifold 70 and/or return manifold 72 associated with a plurality of heat recovery heat exchangers 56a, 56b, 56c, 56d may be directly fluidly connected to the fins 90 that form the second portion 82 of the heat recovery heat exchangers 56a, 56b, 56c, 56d.

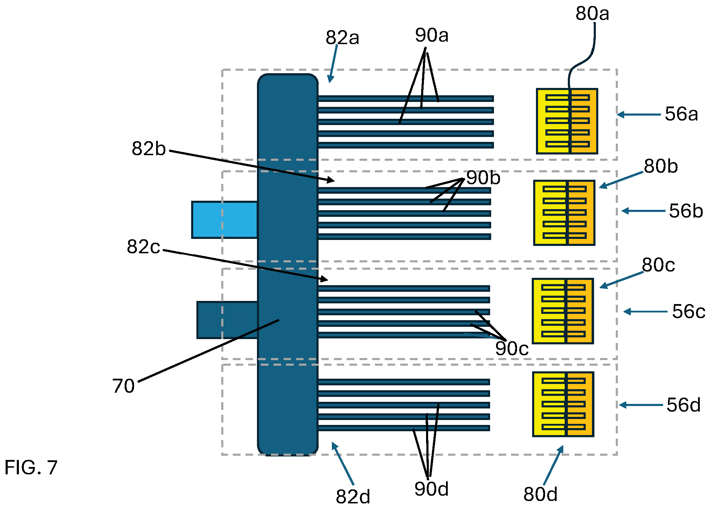

In some embodiments, such as shown in FIG. 7, the fins 90 are integrally formed with the respective manifolds 70, 72. In such embodiments, the manifolds 70, 72 form the base from which the fins 90a, 90b, 90c, 90d extend for each of the plurality of heat recovery heat exchangers 56a, 56b, 56c, 56d of the rack system 52. Accordingly, a flow of coolant C is provided to the one or more flow channels of the plurality of fins 90a, 90b, 90c, 90d associated with each respective heat recovery heat exchanger 56a, 56b, 56c, 56d in parallel. Similarly, the coolant C output from each of the plurality of fins 90a, 90b, 90c, 90d associated with each respective heat recovery heat exchanger 56a, 56b, 56c, 56d is provided directly to the return manifold 72 in parallel. Accordingly, no mixing of any of the flows of coolant C exiting the one or more flow channels of the fins 90a, 90b, 90c, 90d occurs upstream from the return manifold 72.

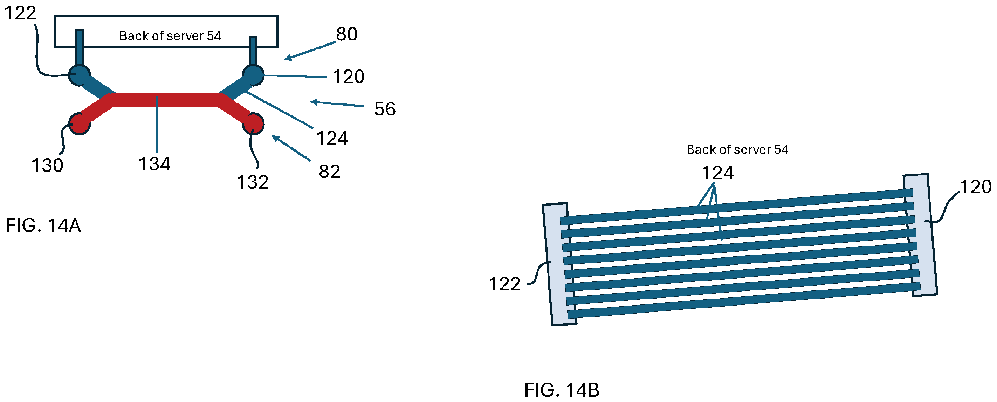

With reference to FIGS. 14A-14B, a heat recovery heat exchanger assembly 56 representative of any of the heat recovery heat exchangers 56a, 56b, 56c, 56d of FIG. 2 is illustrated. As in the previous embodiments, the heat recovery heat exchanger assembly 56 includes a first portion 80 associated with a first pathway of the rack cooling circuit 64 and a second portion 82 associated with a second pathway of the secondary cooling circuit 33. However, in the illustrated, non-limiting embodiment, each portion 80, 82 of the heat recovery heat exchanger assembly 56 is a heat exchanger, such as located at or proximate an end of the server 54 for example. As shown, the first portion 80 includes a first, supply manifold 120 and a second, return manifold 122, separate and spaced apart from the supply manifold, and a plurality of heat exchange tubes 124, such as microchannel heat exchange tubes for example, extending between and fluidly coupling the supply and return manifolds 120, 122.

The second portion 82 may have a similar construction including a plurality of parallel fluid flow paths defined by a plurality of heat exchange tubes 134 extending between a first, supply manifold 130 and a second, return manifold 132. In the illustrated, non-limiting embodiment, the heat exchange tubes 134 of the second portion 82 are interleaved with the heat exchange tubes 124 of the first portion 80. In some embodiments, adjacent heat exchange tubes 124, 134 are clamped via a thermal grease or other suitable material to minimize the thermal resistance between the adjacent heat exchange tubes 124, 134.

As shown, the supply manifold 120 and return manifold 122 of the first portion 80 of the heat rejection heat exchanger assembly 56 may have a substantially vertical orientation. The heat exchange tubes 124 of the first portion 80 are arranged at a non-parallel angle relative to the supply and return manifolds 120, 122. The heat exchange tubes 124 may have a generally horizontal orientation. In the illustrated, non-limiting embodiment, the heat exchange tubes 124 of the first portion 80 are sloped relative to a horizontal plane to facilitate the flow of the working fluid W therein toward the return manifold 122. Alternatively, or in addition, a pump may be used to circulate the working fluid R through the first pathway.

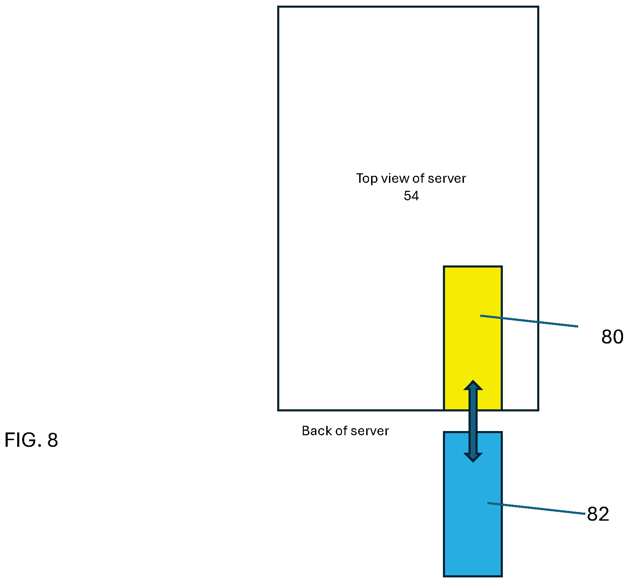

When a server 54 of a rack system 52 needs to be replaced, the first portion 80 of the heat recovery heat exchanger 56 is disengaged or separated from the second portion 82 of the heat recovery heat exchanger 56 as the server 54 is removed from the rack system 52. In some embodiments, such as shown in FIG. 3 for example, the heat recovery heat exchanger 56, and therefore the first portion 80 thereof, is fluidly connected to the server 54, but is physically spaced therefrom, such as from the printed circuit board or the structural body of the server 54 for example. However, in other embodiments, such as shown in FIG. 8, the first portion 80 may be integrated into the server 54, such as affixed to or embedded within the structural body of the server 54.

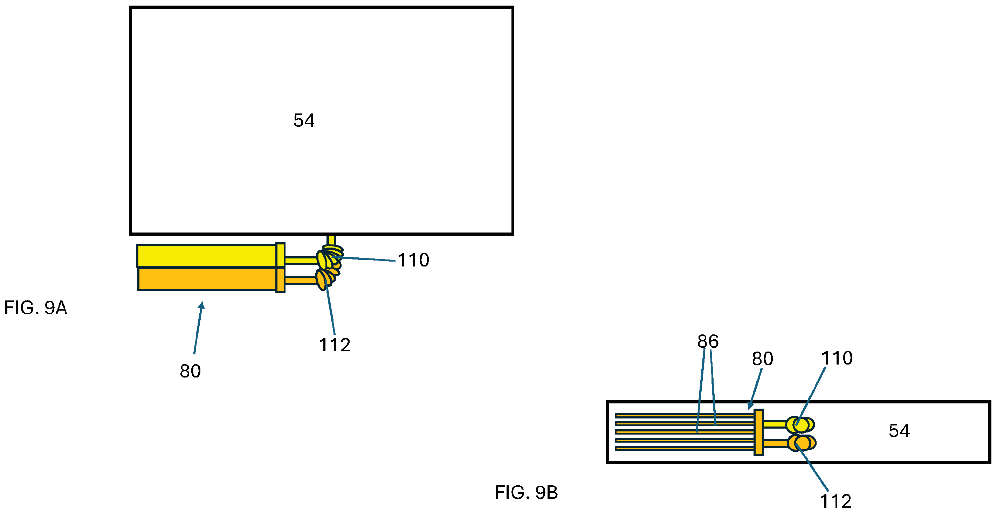

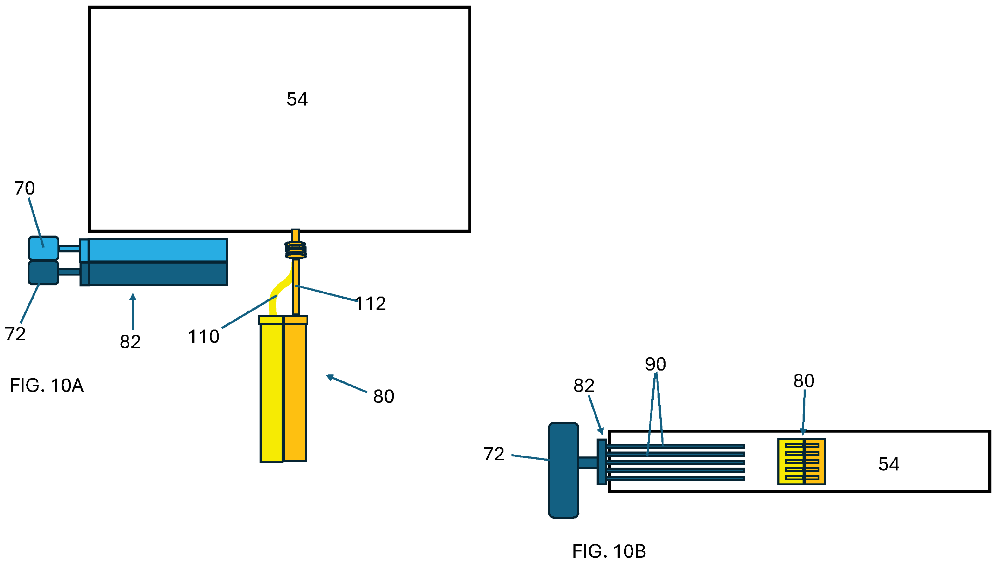

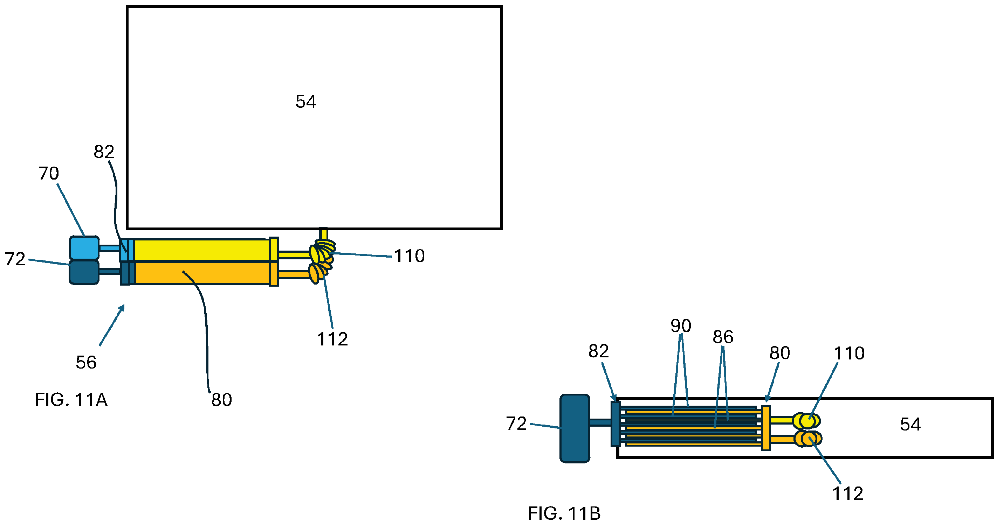

In embodiments where the heat recovery heat exchanger 56 is arranged at a location offset from the body of the server 54, an orientation of the first portion 80 may be adjustable relative to the server 54 to facilitate installation of the server 54 within a rack system 52. In the non-limiting embodiment of FIGS. 9A-11B, the first portion 80 of the heat recovery heat exchanger 56 has a first orientation (FIGS. 9A, 9B, 11A, 11B), generally parallel to an adjacent side of the server 54 from which the first portion 80 extends. The first portion 80 may have such a configuration during transportation of the server 54, or after installation of the server 54 withing a rack system 52. In the illustrated, non-limiting embodiment, the conduits or connections 110, 112 extending between the first portion 80 of the heat recovery heat exchanger 56 and the server 54 include a bend, such as a 90 degree bend for example, to achieve this first, parallel orientation. The conduits 110, 112 may be flexible such that during or directly prior to installation of the server 54 within the rack system 52, the first portion 80 is adjusted to a second orientation. In the second orientation, shown in FIGS. 10A and 10B, the first portion 80 may be oriented substantially perpendicular to the adjacent side of the server 54 from which the first portion 80 extends. In the second orientation, the conduits or connections 110, 112 fluidly connecting the first portion 80 to the server 54 may have a substantially linear configuration. In an embodiment, once the first portion 80 of the heat recovery heat exchanger 56 is engaged and arranged in surface contact with the second portion 82 of the heat recovery heat exchanger 56, the conduits 110, 112 may be bent to properly position the server 54 within the rack system 52.

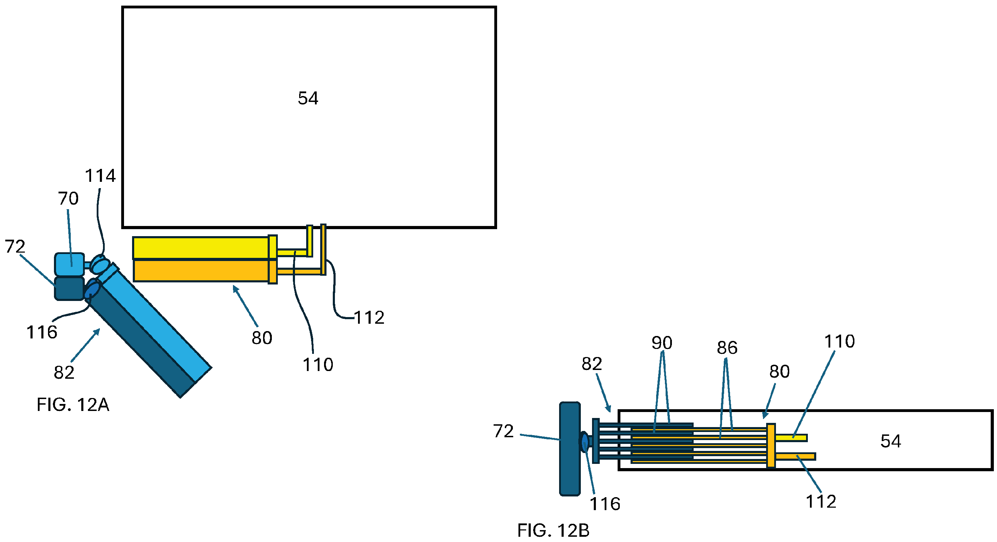

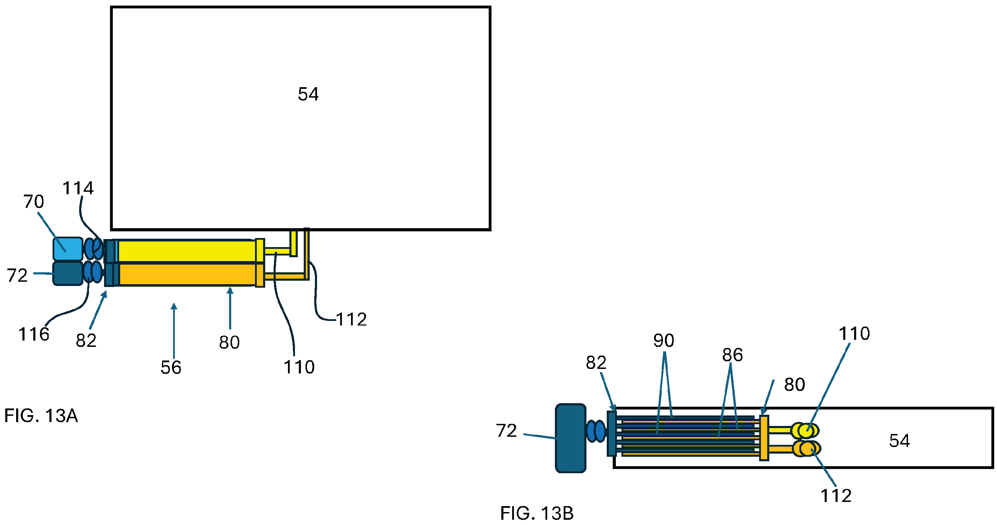

Alternatively, or in addition, the orientation of the second portion 82 of the heat recovery heat exchanger 56 is adjustable relative to the server 54 and/or the rack system 52. With reference to FIGS. 12A-13B, the conduits 114, 116 extending between the supply manifold 70 and the return manifold 72, and the second portion 82 of the heat recovery heat exchanger 56 may be flexible to allow bending or rotation of the second portion 82. In the illustrated, non-limiting embodiment, the conduits 110, 112 fluidly connected the first portion 80 of the heat recovery heat exchanger 56 are fixed in position relative to the server 54. However, embodiments where the conduits 110, 112, 114, 116 associated with both portions 80, 82 of the heat recovery heat exchanger 56 are flexible are also contemplated herein. As shown in FIGS. 12A-12B, prior to installation of a server 54, the fins 90 of the second portion 82 may be arranged at a non-parallel angle relative to the fins 86 of the first portion 80. In an embodiment, the angle is between 1 degree and 90 degrees. As the server 54 is moved towards the second portion 82 and the fins 86 of the first portion 80 engage with the fins 90 of the second portion 82, see FIGS. 13A-13B, the conduits 114, 116 fluidly connected to the second portion 82 may flex to align the first portion 80 and the second portion 82 in a coaxial manner such that the fins 86, 90 are properly positioned relative to one another.

A rack cooling circuit 64 that is selectively couplable to the second cooling system 32 results in high level of cooling reliability by eliminating the need for connections between a heat transfer element and the heat recovery heat exchanger 56. Further, such a configuration provides enhances the ease of installing and removing servers 54 from a rack system 52.

The term "about" is intended to include the degree of error associated with measurement of the particular quantity based upon the equipment available at the time of filing the application.

The terminology used herein is for the purpose of describing particular embodiments only and is not intended to be limiting of the present invention. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present invention has been described with reference to an exemplary embodiment or embodiments, it will be understood by those skilled in the art that various changes may be made and equivalents may be substituted for elements thereof without departing from the scope of the present invention as defined by the appended claims. In addition, many modifications may be made to adapt a particular situation or material to the teachings of the present invention without departing from the scope of the present invention as defined by the appended claims. Therefore, it is intended that the present invention not be limited to the particular embodiment disclosed as the best mode contemplated for carrying out this present invention, but that the present invention will include all embodiments falling within the scope of the claims.

## Claims

1. A cooling system for a server (54) mounted in a rack (52) of a data center (50), the cooling system comprising:
a first portion (80) of a heat recovery heat exchanger (56);
a rack cooling circuit (64) fluidly connected to the first portion (80) of the heat recovery heat exchanger (56) and fluidly connectable to the server (54), wherein a working fluid (W) is circulatable through the rack cooling circuit (64);
wherein the first portion (80) of the heat recovery heat exchanger (56) is movable between an engaged position and a disengaged position, wherein in the engaged position, the first portion (80) of the heat recovery heat exchanger (56) is engaged with a second portion (86) of the heat recovery heat exchanger (56) located at the rack (52) of the data center (50), and in the disengaged position, the first portion (80) of the heat recovery heat exchanger (56) is located remotely from the second portion (82) of the heat recovery heat exchanger (56).

2. A data center (50) comprising:
a rack (52);
a server (54) removably mountable within the rack (52);
a rack cooling circuit (64) including a first portion (80) of a heat recovery heat exchanger (56) and the server (54), a working fluid (W) being circulatable through the rack cooling circuit (64); and
a secondary cooling circuit (32) including a second portion (82) of the heat recovery heat exchanger (56), a coolant (C) being circulatable through the secondary cooling circuit (32), wherein the secondary cooling circuit (32) is fluidly separate from the rack cooling circuit (64); and
wherein the first portion (80) of the heat recovery heat exchanger (56) is movable relative to the second portion (82) of the heat recovery heat exchanger (56) between an engaged position and a disengaged position, in the engaged position, the first portion (80) of the heat recovery heat exchanger (56) and the second portion (82) of the heat recovery heat exchanger (56) are engaged and in the disengaged position, the first portion (80) of the heat recovery heat exchanger (56) is located remotely from the second portion (82) of the heat recovery heat exchanger (56).

3. The cooling system (20) of claim 1, or the data center (50) of claim 2, wherein the first portion (80) of the heat recovery heat exchanger (56) is thermally coupled to the second portion (82) of the heat recovery heat exchanger (56) only when in the engaged position.

4. The cooling system (20) of claim 1 or 3, or the data center (50) of claim 2 or 3, wherein the first portion (80) of the heat recovery heat exchanger (56) is mechanically coupled to the second portion (82) of the heat recovery heat exchanger (56) only when in the engaged position.

5. The cooling system (20) of any of claims 1, 3 or 4, or the data center (50) of any of claims 2, 3 or 4, wherein the first portion (80) of the heat recovery heat exchanger (56) includes at least one first engagement feature (86), and in the engaged position, the at least one first engagement feature (86) is interleaved with at least one second engagement feature (90) of the second portion (82) of the heat recovery heat exchanger (56).

6. The cooling system (20) of claim 5, wherein the at least one first engagement feature includes a plurality of first fins (86) and a plurality of first cavities (87) defined between adjacent first fins of the plurality of first fins.

7. The cooling system (20) of claim 5 or 6, wherein the at least one second engagement feature includes a plurality of second fins (90) and a plurality of second cavities (91) defined between adjacent second fins of the plurality of first fins.

8. The cooling system (20) of claim 7, wherein a size and shape of each of the plurality of second fins (90) is identical to the size and shape of a corresponding first cavity of the plurality of first cavities (87).

9. The cooling system of claim 7 or 8, wherein a size and shape of each of the plurality of first fins (86) is identical to the size and shape of a corresponding second cavity of the plurality of second cavities (91).

10. The cooling system (20) of claim 5, wherein an orientation one or more of the at least one first engagement feature (86) and the at least one second engagement (90) feature is adjustable relative to the server.

11. The cooling system (20) of any of claim 1 or claims 3-10, wherein the server (54) has a structural body and the first portion (80) of the heat recovery heat exchanger is located remotely from the structural body;
and/or
wherein the server has a structural body and the first portion (80) of the heat recovery heat exchanger (54) is integrated into the structural body.

12. The data center (50) of any of claims 2-5, wherein the working fluid (W) is a refrigerant, and the working fluid (W) received at the first portion (80) of the heat recovery heat exchanger (56) is a two-phase mixture.

13. The data center (50) of any of claims 2-5 or 12, wherein the coolant (C) is water.

14. The data center (50) of any of claims 2-5, 12 or 13, wherein at least one heat transfer element (62) is thermally coupled to a heat-generating electrical device (60) of the server (54), the at least one heat transfer element (62) being fluidly coupled to the rack cooling circuit (64).

15. The data center (50) of any of claims 2-5 or 12-14, wherein the rack cooling circuit (64) is configured as a thermosiphon;
and/or
wherein the rack cooling circuit (64) includes a pump operable to circulate working fluid (W) through the rack cooling circuit (64).
